# FASCICULE DE BREVET EUROPEEN

(11) **EP 1 606 934 B1**
(45) Date de publication et mention de la délivrance du brevet: **16.08.2006**
(21) Numéro de dépôt: 04741424.8
(22) Date de dépôt: 05.03.2004
(51) Int. Cl.: H04N 3/15

(54) **CAPTEUR D'IMAGE A CYCLE DE LECTURE RAPIDE**
BILDSENSOR MIT SCHNELLEM LESEZYKLUS
IMAGE SENSOR WITH RAPID READ CYCLE

(30) Priorité: 21.03.2003 FR 0303511
(43) Date de publication de la demande: 21.12.2005
(73) Titulaire: Atmel Grenoble, 38120 Saint-Egrève (FR)
(72) Inventeur: FEREYRE, Pierre, THALES Intellectual Property, F-94117 ARCUEIL (FR); LIGOZAT, Thierry, THALES Intellectual Property, F-94117 ARCUEIL (FR)
(74) Mandataire: Guérin, Michel
(86) Numéro de dépôt international: PCT/EP2004/050264
(87) Numéro de publication internationale: WO 2004/084541

(56) Documents cités:
- US-A1- 2002 154 236
- PATENT ABSTRACTS OF JAPAN vol. 018, no. 407 (E-1586), 29 juillet 1994 (1994-07-29) & JP 06 121235 A (SHARP CORP), 28 avril 1994 (1994-04-28)

## Description

L'invention concerne les capteurs d'image électroniques, et plus particulièrement les capteurs comportant une matrice de prise d'image de grand format (plusieurs milliers de lignes et plusieurs milliers de colonnes de points d'image).

Les matrices de grande taille posent un problème spécifique qui est celui du temps nécessaire à la lecture de l'image enregistrée dans la matrice : il faut vider la matrice ligne par ligne dans un registre de lecture placé à l'extrémité des colonnes de la matrice jusqu'à ce que toutes les lignes aient été vidées ; mais, entre le déversement d'une ligne de matrice dans le registre et le déversement de la ligne suivante, il faut lire le contenu du registre en le vidant étage par étage dans un circuit de lecture placé en bout du registre.

Pour obtenir une cadence suffisamment élevée (par exemple la cadence typique d'une prise de vue vidéo à 30 images par seconde), il faut à la fois que le registre de lecture travaille à cadence extrêmement élevée et que les phases de transfert en colonne ne prennent pas trop de temps.

Pour améliorer les performances, on a déjà proposé de diviser la matrice à la fois horizontalement et verticalement en deux parties, donc en quatre quadrants, et de placer à l'extrémité libre des colonnes de chaque cadran un registre de lecture spécifique. Il y a donc quatre registres de lecture et les contraintes de chaque registre sont les contraintes correspondant à une matrice de taille réduite.

Même lorsque cette disposition est utilisée, elle ne suffit pas forcément et on peut souhaiter accélérer le processus de lecture de l'image.

On peut aussi prévoir, mais cela entraîne des contraintes de conception topographiques supplémentaires et des contraintes de multiplexage des diverses sorties des registres, que les registres ont des sorties intermédiaires au lieu d'avoir une seule sortie en bout de registre.

L'invention vise à proposer une solution simple d'amélioration de la vitesse de lecture, qui peut d'ailleurs être utilisée en combinaison avec les solutions qui viennent d'être exposées (multiples registres et registres à sorties multiples).

Pour expliquer l'invention, on rappelle que dans un capteur d'image classique :
- les colonnes de la matrice de prise d'image sont organisées chacune en registre à transfert de charges en colonne pour décaler progressivement les charges d'un point d'image d'une ligne à l'autre à l'intérieur de chaque colonne, chaque étage du registre en colonne correspondant à un point d'image ;
- chaque étage du registre en colonne comprend plusieurs électrodes (typiquement quatre électrodes pour une matrice classique) ; le transfert de charges en colonne d'un étage au suivant, de même que le transfert de la dernière ligne vers le registre de lecture, s'effectue en plusieurs coups d'horloge successifs d'une horloge de cadencement vertical ; les coups d'horloge correspondent à des commandes des différentes électrodes de l'étage, en synchronisme pour les électrodes de même rang de toutes les lignes de la matrice ;
- entre la dernière ligne de points de la matrice de prise d'image et le registre de lecture situé à l'extrémité des colonnes de la matrice, il y a une électrode de transfert qui est commandée en synchronisme avec le transfert en colonne, pour déverser dans le registre de lecture les charges de la dernière ligne, en même temps que les charges avancent d'une ligne à la suivante dans le reste de la matrice ;
- entre deux transferts de charge successifs en colonne, on prend le temps de vider en ligne successivement tous les étages du registre de lecture, sous la commande d'une horloge de cadencement horizontal ; la fréquence de l'horloge de cadencement horizontal, pour le transfert en ligne, est beaucoup plus rapide que la fréquence de l'horloge de cadencement vertical, utilisée pour le transfert en colonne.

Les cadences, tant verticales qu'horizontales, ne peuvent pas monter au dessus de certaines valeurs, qui sont dictées par les capacités et résistances parasites des électrodes et la puissance des amplificateurs qui commutent entre un niveau haut et un niveau bas les potentiels appliqués aux électrodes. Les signaux de commande du registre de lecture, pilotés à la cadence horizontale, commandent de très petites électrodes (celles du registre horizontal) et la cadence peut être rapide. Mais l'horloge de cadencement vertical est beaucoup plus lente à cause du fait que les amplificateurs doivent contrôler simultanément N électrodes (pour N lignes de matrice), électrodes dont les résistances et capacités parasites sont élevées puisque chacune de ces N électrodes occupe toute la largeur de la matrice.

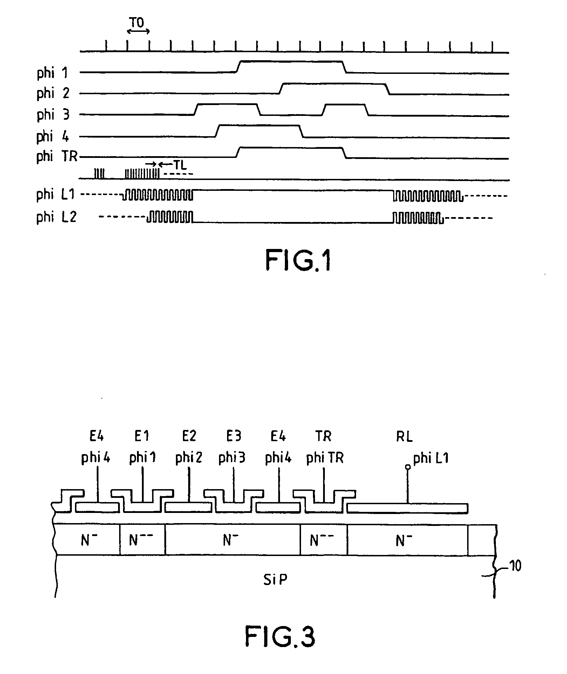

La figure 1 représente sous forme simplifiée un chronogramme classique de lecture d'une matrice de prise d'image dont les colonnes sont agencées en registre de transfert à quatre électrodes par ligne, et dans laquelle le transfert des charges d'une ligne de points à la suivante utilise dix coups d'une horloge de cadencement vertical de période élémentaire T0. Un transfert en dix coups est classique pour des registres à quatre électrodes par étage fonctionnant en mode MPP (« multi-pinned phase » en anglais). D'autres modes sont possibles et utilisent un nombre variable d'électrodes et un nombre variable de coups d'horloge pour faire avancer d'une ligne le transfert de charges en colonne.

La première ligne du chronogramme représente les impulsions de l'horloge de cadencement vertical, dont la période est T0. Les quatre lignes suivantes représentent les signaux de commande phi1, phi2, phi3, phi4 des quatre électrodes successives d'une ligne de la matrice. Toutes les électrodes de même rang des différentes lignes sont commandées par les mêmes signaux, c'est-à-dire que la première électrode (rang 1) de n'importe quelle ligne est commandée par le signal phi1, la deuxième électrode (rang 2) de n'importe quelle ligne est commandée par le signal phi2, et de même pour les signaux phi3 et phi4 qui commandent respectivement toutes les troisièmes électrodes et toutes les quatrièmes électrodes.

La sixième ligne du chronogramme représente la commande d'une électrode dite électrode de transfert, située entre la dernière ligne de points de la matrice et le registre de lecture horizontal. Cette électrode de transfert est commandée par un signal de commande phiTR, pour abaisser périodiquement, en synchronisme avec le décalage vertical des charges d'une ligne à l'autre, une barrière de potentiel créée par cette électrode entre les colonnes et le registre de lecture ; cet abaissement de barrière provoque le vidage des charges de la dernière ligne dans le registre, après quoi la fin du créneau phiTR (passage au niveau bas) remonte la barrière de potentiel pendant tout le temps que va durer le vidage horizontal du registre de lecture. Le signal phiTR est en général le même que phi1.

La septième ligne du chronogramme représente les impulsions de cadencement horizontal, de période TL beaucoup plus courte que T0 car le registre de lecture peut effectuer un transfert de charges en ligne beaucoup plus rapide que le transfert de charges en colonne. Les ordres de grandeur, non respectés sur la figure 1, sont de l'ordre de 2 microsecondes pour T0 et 25 nanosecondes pour TL, pour une matrice de 1000 lignes et 1000 colonnes.

Les huitième et neuvième lignes du chronogramme représentent symboliquement les deux signaux de commande phiL1 et phiL2 du registre horizontal (classiquement un registre à deux phases et à deux électrodes par étage du registre) ; la commutation de ces signaux est rythmée par l'horloge à période TL ; les signaux phiL1 et phiL2 sont interrompus pendant toute la phase de transfert vertical d'une ligne, qui dure environ 20 microsecondes dans cet exemple ; ils reprennent ensuite pour un nouveau vidage horizontal.

On comprend donc que d'une part les signaux phiL1 et phiL2 de transfert horizontal sont actionnés K fois s'il y a K colonnes à lire dans la matrice (correspondant à K étages du registre de lecture horizontal), pour vider le registre horizontal ; puis une succession de créneaux phi1, phi2, phi3, phi4, phiTR tels que représentés sur la figure 1 est établie pour transférer une nouvelle ligne de la matrice dans le registre de lecture ; puis le registre de lecture est vidé par K actionnements des signaux phiL1 et phiL2.

Ce processus est répété N fois s'il y a N lignes dans la matrice. A la fin, la matrice aura été complètement lue et une nouvelle réception d'image peut avoir lieu.

Pour améliorer la rapidité de lecture de la matrice, l'invention propose de poursuivre le transfert horizontal dans le registre de lecture même pendant que les signaux de décalage verticaux d'une ligne à l'autre se poursuivent, sans cependant poursuivre le transfert horizontal pendant l'ouverture de la porte de transfert entre colonnes et registre horizontal. Le temps de vidage du registre de lecture horizontal empiète donc sur le temps réservé à chaque étape de transfert vertical, au lieu que ces temps soient additionnés. Le gain de temps se répète à chaque ligne, ce qui est d'autant plus significatif que le nombre de lignes est plus élevé.

Par conséquent, l'invention propose un capteur d'image comprenant une matrice de prise de vue ayant N lignes et K colonnes de points d'image, un registre de lecture à l'extrémité libre des K colonnes, et des moyens pour transférer d'une ligne à l'autre, et de la dernière ligne au registre de lecture, des charges correspondant aux points d'image, avec une électrode de transfert entre la dernière ligne de la matrice et le registre de lecture, chaque ligne de points d'image comprenant plusieurs électrodes de rang 1 à p, actionnées en synchronisme, de telle sorte que les électrodes de même rang j, avec j=1 à p de toutes les lignes soient actionnées par un même signal de commande périodique, l'électrode de rang p étant, parmi les électrodes d'une même ligne, celle qui est la plus proche du registre de lecture, des moyens de commande du registre de lecture étant prévus pour effectuer un transfert de charges du registre vers un circuit de lecture, interrompre ce transfert pendant qu'une barrière de potentiel sous l'électrode de transfert est abaissée, et reprendre ce transfert ensuite, ce capteur d'image étant caractérisé en ce que les moyens de commande sont agencés pour effectuer un transfert de charges d'une part pendant que les électrodes de ligne ne subissent aucune commutation de niveau de potentiel, et d'autre part pendant que les électrodes d'au moins un des rangs j = 1 à j = p subissent une commutation de niveau lors d'une opération de transfert de charges en colonne, le transfert par le registrer de lecture étant interrompu pendant que ladite barrière de potentiel sous l'électrode de transfert (TR) est abaissée.

Le transfert par le registre de lecture peut être poursuivi, selon l'invention, pendant toute la durée où les différentes électrodes de rang j = 1 à p subissent des commutations (sauf pendant le temps où la barrière de potentiel sous l'électrode de transfert est abaissée). Il peut même être poursuivi pendant une partie du temps où les électrodes de rang 1 de la matrice sont à un niveau de potentiel haut, à condition toutefois que l'électrode de transfert entre matrice et registre de lecture soit commandée pour autoriser le transfert de charges de la matrice au registre pendant une durée plus courte que la durée de passage au potentiel haut des électrodes de rang 1. Le potentiel haut appliqué à une électrode est celui qui définit l'abaissement d'une barrière de potentiel ou le creusement d'un puits de potentiel sous cette électrode ; le potentiel bas est celui qui élève une barrière de potentiel ou fait remonter le fond d'un puits de potentiel formé sous l'électrode.

On prévoit donc de préférence que l'électrode de transfert est commandée par un signal de commande qui n'est pas le même que celui qui commande les électrodes de rang 1 (mais qui commence et se termine pendant que les électrodes de rang 1 sont au potentiel haut).

On peut prévoir que l'électrode de rang p de la dernière ligne de la matrice, celle qui est adjacente à l'électrode de transfert, a une surface plus grande que les autres électrodes de rang p de la matrice, afin de pouvoir stocker la totalité des charges sous cette électrode. On prévoit de préférence aussi qu'elle est commandée par un signal indépendant de celui des autres électrodes de même rang p. Cette électrode et l'électrode de transfert sont de préférence réalisées avec une résistivité plus faible que les autres électrodes de ligne de la matrice (en pratique elles sont en silicium polycristallin doublé par une couche d'aluminium) afin de pouvoir être commandées très rapidement.

Enfin, la sortie du registre de lecture aboutit sur un circuit de lecture qui comprend en principe un convertisseur charge/tension (constitué essentiellement par une simple diode de lecture recueillant les charges du registre) et un amplificateur réalisés sur la même puce de circuit intégré (en silicium) que la matrice, et on propose selon l'invention que l'amplificateur au moins soit de préférence agencé physiquement de manière à être découplé du corps du substrat de circuit-intégré. En effet, le corps du substrat de circuit intégré tend à subir des variations de potentiel lors des commutations du réseau de N lignes de p électrodes, et ces variations de potentiel de substrat seraient néfastes si elles se retransmettaient au circuit de lecture pendant la lecture des charges du registre.

On prévoit donc des moyens pour neutraliser l'effet sur l'amplificateur des variations de potentiel du silicium lors des commutations de niveau de potentiel des électrodes de ligne de la matrice. Ces moyens comprennent par exemple une électrode formée sur la même face de substrat que les électrodes de la matrice, cette électrode entourant l'amplificateur, et des moyens pour relier cette électrode à un potentiel fixe de masse. Ces moyens de neutralisation peuvent aussi comprendre une tranchée dans le silicium autour de l'amplificateur et des moyens pour relier à un potentiel fixe de masse la portion de substrat entourée par cette tranchée.

L'invention est particulièrement intéressante pour les matrices de grand format, à très grand nombre de lignes et de colonnes, car le couplage capacitif est très important dans ce cas, et tout spécialement celles qui fonctionnent en mode d'intégration de charges de type MPP qui est un mode à faible bruit.

D'autres caractéristiques et avantages de l'invention apparaîtront à la lecture de la description détaillée qui suit et qui est faite en référence aux dessins annexés dans lesquels :
- la figure 1, déjà décrite, représente un chronogramme de transfert de charges d'une matrice de prise de vue classique ;
- la figure 2 représente une matrice de prise de vue selon l'invention ;
- la figure 3 rappelle la structure en coupe des électrodes de ligne de la matrice ;
- la figure 4 représente un chronogramme de lecture de charges de la matrice de la figure 2.

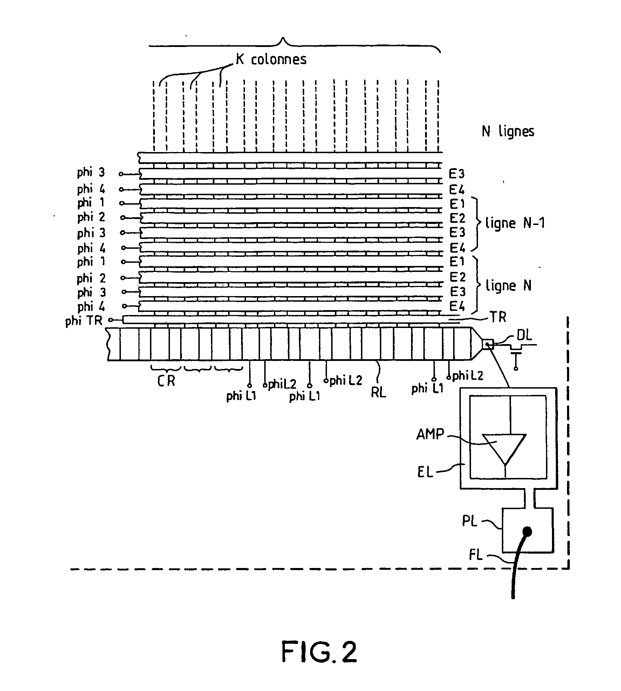

La figure 2 représente une vue partielle d'une matrice de prise d'image, montrant schématiquement les deux dernières lignes N-1 et N de la matrice, l'électrode de transfert TR entre la dernière électrode de la dernière ligne et le registre de lecture horizontal RL. La sortie du registre de lecture débouche sur un circuit de lecture comprenant en principe une diode de lecture DL, et un amplificateur AMP. La diode de lecture, associée à un transistor de remise à niveau périodique, agit comme convertisseur charge/tension pour transformer en niveau de tension proportionnel à la charge chaque paquet de charges déversé dans la diode par le registre de lecture au fur et à mesure de son avance pas-à-pas.

Dans l'exemple représenté, chaque ligne comporte quatre électrodes parallèles de rang j=1 à j=4, respectivement E1, E2, E3, E4 dans l'ordre de la plus éloignée à la plus proche du registre de lecture.

Entre deux opérations successives de transfert de charges en colonne, ces électrodes sont soumises à des potentiels fixes qui permettent le stockage de charges localisées en chaque point d'image au croisement d'une ligne et d'une colonne. Typiquement, (matrice conçue pour fonctionner en mode MPP), les potentiels appliqués aux quatre électrodes d'une ligne sont des potentiels bas sur les électrodes E1 ainsi que sur les électrodes E2, E3 et E4, mais le potentiel à l'intérieur de la couche superficielle de silicium dopé de type N dans laquelle sont stockées et se propagent les charges, est légèrement plus bas sous les électrodes E1 ; ainsi est créé sous les électrodes E2, E3, E4, entre les électrodes E1 de deux lignes successives, un puits de potentiel peu profond mais large dans lequel restent accumulées les charges au croisement de la ligne et de la colonne pendant l'intervalle de temps qui sépare deux étapes élémentaires de transfert en colonne.

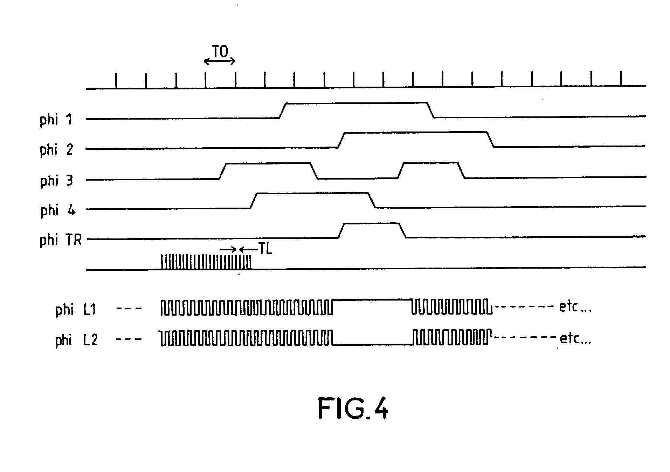

La figure 3 représente en coupe le long d'une colonne la structure physique classique de l'extrémité de la colonne d'une matrice, avec un substrat de silicium 10 de type P, une couche superficielle de type N', moins dopée sous les électrodes E1 et sous l'électrode de transfert TR que sous les électrodes E2, E3, E4, afin de créer, pour un même niveau de potentiel sous toutes les électrodes, une barrière de potentiel sous les électrodes E1 et TR, barrière qui retient les charges stockées sous l'ensemble des électrodes E2, E3, E4, ou dans le registre RL. On rappelle par ailleurs qu'un niveau haut de potentiel positif crée un puits de potentiel plus profond, pour des charges négatives, qu'un niveau bas.

Les colonnes sont séparées par des barrières physiques (oxyde et/ou région dopées négativement) qui isolent les paquets de charges négatives stockés dans les différentes colonnes.

Pendant une opération de transfert élémentaire (transfert de charges d'une ligne à la suivante), des commutations de potentiels successives, identiques pour toutes les électrodes de même rang des différentes lignes de la matrice, sont appliquées pour créer progressivement un décalage de charges depuis les électrodes E2, E3, E4 d'une ligne (par exemple la ligne N-1) jusqu'aux électrodes E2, E3, E4 de la ligne suivante (ligne N). Les signaux de commande phi1, phi2, phi3, phi4 des électrodes E1, E2, E3, E4 respectivement sont représentés sur le chronogramme de la figure 4. Ces signaux sont représentés schématiquement par des niveaux logiques haut et bas. Les niveaux de potentiel créés à l'intérieur du silicium de la matrice sous une électrode ne sont pas représentés pour ne pas compliquer les figures ; on comprendra que ces niveaux de potentiel dépendent à la fois du niveau de potentiel appliqué à l'électrode et du dopage du silicium au dessous de l'électrode. Dans le cas classique des matrices fonctionnant en mode MPP, un puits de potentiel est créé sous les électrodes E2, E3 et E4, et une barrière de potentiel est créée autour de ce puits par les électrodes E1, alors que les potentiels des quatre électrodes sont tous au niveau bas.

Le chronogramme de la figure 4 représente:
- sur sa partie gauche, dans laquelle il n'y a pas de commutation des signaux phi1 à phi4, une phase d'attente qui sépare deux opérations successives de transfert de charges en colonne ;
- dans sa partie centrale, la commutation des signaux phi1 à phi4 correspondant à une étape de transfert de charges d'une ligne à la suivante et de la dernière ligne vers le registre de lecture ;
- et dans sa partie droite, à nouveau une période d'attente d'une nouvelle étape de transfert de charges d'une ligne à la suivante.

L'étape de transfert de charges d'une ligne à la suivante dure, dans l'exemple de matrice MPP utilisé, dix coups d'une horloge de base de période T0 ; les signaux phi1 à phi4 sont établis par un séquenceur non représenté qui fonctionne au rythme de cette horloge T0. La période T0 est typiquement de 2 microsecondes environ pour une matrice de 1000 lignes capable de fournir une image en 1/30 de seconde.

Le chronogramme de la figure 4 représente également le signal de commande phiTR de la porte de transfert TR entre l'électrode E4 de la dernière ligne N et le registre de lecture RL. Classiquement, la porte de transfert est commandée par le même signal phi1 que les électrodes E1 de la matrice. Mais, dans la matrice selon l'invention, on préfère prévoir un signal de commande séparé phiTR pour commander cette électrode ; ce signal phiTR abaisse la barrière de potentiel créée presque en permanence sous l'électrode de transfert TR (barrière entre les colonnes de la matrice et le registre de lecture) ; la durée du signal phiTR au niveau haut, pendant laquelle la barrière de potentiel est abaissée, est de préférence plus courte que la durée du signal phi1 ; l'électrode de transfert est d'ailleurs commandée par un signal qui ne provient pas des amplificateurs de pilotage des électrodes E1 même si le créneau phiTR est identique au créneau phi1. Pendant cette durée du créneau phiTR au niveau haut, les charges peuvent se déverser de la dernière ligne vers le registre de lecture RL.

Le registre de lecture est classiquement organisé avec un étage par colonne de la matrice, deux électrodes par étage, et deux signaux en opposition de phase, phiL1 et phiL2, pour la commande de ces électrodes. Les charges sont initialement déversées sous une des électrodes (électrode commandée par le signal phiL1 dans l'exemple décrit et c'est pourquoi phiL1 est au niveau de potentiel haut pendant la durée du créneau phiTR) ; puis, lorsque le registre de lecture est actionné en mode de lecture, les charges sont décalées horizontalement pas-à-pas sous l'électrode suivante (vers la droite sur la figure 2), au fur et à mesure de la commutation alternée des phases phiL1 et phiL2, jusqu'à atteindre les circuits de lecture.

Les circuits de lecture en sortie du registre de lecture comprennent classiquement un convertisseur charge/tension et un amplificateur de tension ; le convertisseur est constitué d'une part par la diode de lecture DL dans laquelle sont déversées les charges arrivant périodiquement à la cadence d'avance du registre de lecture et d'autre part par un circuit de remise à niveau du potentiel de la diode après chaque lecture.

La cadence d'avance du registre de lecture (cadence de commutation des phases phiL1 et phiL2) est définie par une horloge de période TL beaucoup plus courte que T0, et il faut deux coups d'horloge TL pour faire avancer d'un étage les charges, le registre de lecture étant en principe un registre à deux phases.

Pendant le transfert de charges des colonnes vers le registre de lecture, on interrompt le transfert horizontal des charges dans le registre de lecture et, à cet effet, les signaux de commande phiL1 et phiL2 du registre sont arrêtés. Mais, alors que classiquement on arrêtait les signaux phiL1 et phiL2 (voir figure 1) pendant toute la durée de commutation des phases phi1 à phi4 (10 coups d'horloge T0 en mode MPP), on propose selon l'invention de n'arrêter la commutation des phases phiL1 et phiL2 que pendant une durée beaucoup plus brève qui est la durée d'abaissement de la barrière de potentiel sous l'électrode de transfert TR, c'est-à-dire la durée du créneau phiTR au niveau haut. Cette durée est de 1 à 3 fois la période T0, ou au maximum 5 fois T0 dans le cas extrême où la durée du créneau phTR est égale à celle du créneau phi1.

Dans l'art antérieur l'arrêt du transfert horizontal pouvait durer environ 20 microsecondes pour une période T0 de 2 microsecondes. Dans la matrice selon l'invention, on arrête le transfert horizontal pendant une durée qui peut se limiter à 4 à 10 microsecondes.

A titre indicatif, pour 1000 colonnes à une cadence horizontale TL de 12,5 nanosecondes, donc 25 nanosecondes par pas de transfert horizontal, le vidage du registre horizontal RL prend 25 microsecondes. Le décalage d'une ligne de matrice dans le transfert vertical prend environ 20 microsecondes pour une cadence d'horloge verticale de T0=2 microsecondes.

Au total, le temps de cycle pour la lecture d'une ligne prend donc 45 microsecondes si on additionne le temps de lecture horizontal et le temps d'incrémentation d'une ligne dans le transfert en colonne. Avec l'invention, en limitant à 2T0 ou à peine plus, soit environ 4 à 5 microsecondes, le temps pendant lequel le transfert horizontal est interrompu, on trouve un temps de cycle total de 25 + 5 microsecondes soit 30 microsecondes pour la lecture d'une ligne complète au lieu de 45 microsecondes.

On a donc ainsi gagné, dans cet exemple, 15 microsecondes soit plus de 30% d'amélioration de la rapidité de lecture de l'ensemble de la matrice.

Si on détaille le fonctionnement de type MPP de la matrice, la succession des dix étapes aboutissant à une incrémentation d'une ligne dans le transfert en colonne est dans l'ordre la suivante pour l'ensemble des lignes sauf la dernière (celle-ci sera décrite plus loin) :
- 0. départ avec les signaux phi1, phi2, phi3, phi4 au niveau bas ; les charges photogénérées sont stockées sous les électrodes E2, E3, E4 des lignes de la matrice ;
- 1. montée de phi3, les charges se concentrent principalement sous E3 ;
- 2. montée de phi4, les charges se répartissent principalement sous E3 et E4 ;
- 3. montée de phi1, les charges se répartissent sous E3, E4 et sous l'électrode E1 de la ligne suivante ;
- 4. descente de phi3, les charges qui étaient sous E3 se concentrent sous l'électrode E4 et sous l'électrode E1 de la ligne suivante
- 5. montée de phi2, les charges se répartissent principalement entre l'électrode E4 et l'électrode E2 de la ligne suivante ;
- 6. descente de phi4, les charges sont réparties sous les électrodes E1 et E2 de la ligne suivante (désormais elles sont toutes sous les électrodes de la ligne suivante)
- 7. remontée de phi3, les charges sont sous E1, E2, E3 (principalement E2, E3) ;
- 8. descente de phi1, les charges se concentrent principalement sous E2 et E3 ;
- 9. descente de phi3, les charges se concentrent principalement sous E2 ;
- 10. descente de phi2, les charges se répartissent sous E2, E3, E4 et on est revenu à l'état initial, les charges ayant avancé d'une ligne.

Pour la dernière ligne de la matrice, le processus est le suivant dans le cas où le signal phiTR passe et reste au niveau haut en même temps que phi1 :
- 1. montée de phi3, les charges se concentrent principalement sous E3 ;
- 2. montée de phi4, les charges se répartissent principalement sous E3 et E4 ;
- 3. montée de phi1 et de phiTR : abaissement de la barrière de potentiel entre l'électrode E4 et le registre de lecture : les charges présentes sous E4 commencent à se déverser dans le registre ; accueil possible de nouvelles charges sous E1, en provenance de l'avant dernière ligne
- 4. descente de phi3, les charges qui étaient sous E3 sont poussées vers l'électrode E4 et de là continuent à se déverser dans le registre de lecture ;
- 5. montée de phi2, pas de changement sauf en ce qui concerne les charges arrivées de l'avant dernière ligne mais ces charges restent isolées de celles qui se déversent dans le registre de lecture ;
- 6. descente de phi4, le restant de charges sous E4 finit de se déverser dans le registre de lecture ;
- 7. remontée de phi3, pas de changement ; les charges arrivées de l'avant dernière ligne sont sous E1, E2, E3 ;
- 8. descente de phi1 et phiTR ; fermeture de la barrière entre les colonnes et le registre de lecture ; les charges arrivées de la dernière ligne sont alors principalement sous E2, E3 ;
- 9. descente de phi3, les charges se concentrent principalement sous E2 ; la barrière est fermée ;
- 10. descente de phi2, les charges se répartissent sous E2, E3, E4 et on est revenu à l'état initial, les charges ayant avancé d'une ligne ; la barrière est fermée.

Mais dans la solution préférée, le créneau phiTR est plus court que le créneau phi1 et dans ce cas l'ouverture de la barrière de potentiel entre les colonnes et le registre de lecture peut commencer après l'étape 3, par exemple à l'étape 4 ou l'étape 5 (avant la descente de phi4) ; le créneau phiTR peut aussi redescendre avant l'étape 8, de préférence à l'étape 7 (mais il faut attendre la descente de phi4 car la descente de phi4 est nécessaire pour finir de pousser les charges dans le registre). Une bonne solution est la montée de phiTR à l'étape 5 et la descente à l'étape 7, avec une durée de 2TO. Cependant, il est possible de réduire encore la durée du créneau phiTR à une valeur d'environ T0 si on démarre ce créneau une demi-période avant l'étape 6 (descente de phit4) et si on le termine une demi-période après cette étape 6.

En résumé par conséquent, le capteur comprend des moyens pour :
- abaisser la barrière de potentiel sous l'électrode de transfert (TR) en même temps que ou après le passage à un niveau logique haut des électrodes de rang 2 et pendant que l'électrode de rang 4 est au niveau haut, et pour
- remonter cette barrière de potentiel avant ou en même temps qu'un passage de l'électrode de rang 3 à un niveau logique haut et alors que l'électrode de rang 4 est revenue au niveau bas.

Pour permettre d'obtenir d'une manière optimale le chronogramme de la figure 4, il est souhaitable que l'électrode de transfert TR réagisse très rapidement au signal de commande phiTR lorsqu'il monte ou descend. Il est donc préférable que cette électrode soit plus conductrice que les autres électrodes E1 à E4 de la matrice. Pour cela, alors que les électrodes de la matrice sont généralement en silicium polycristallin dopé, on prévoit de doubler l'électrode TR par une couche d'aluminium. On fait de préférence la même chose aussi pour l'électrode qui lui est adjacente, à savoir la dernière électrode E4 de la dernière ligne N, et on prévoit de commander cette électrode E4 par un amplificateur séparé de l'amplificateur qui commande toutes les électrodes E4 des autres lignes. Ainsi, l'électrode E4 de la dernière ligne ne sera pas affectée par l'imprécision de commutation des signaux phi4 ; sa commutation sera mieux contrôlée et le chronogramme de la figure 4 sera plus facilement respecté ; les charges présentes sous la dernière électrode E4 auront le temps de se déverser dans le registre de lecture malgré le temps bref imparti pour ce déversement. C'est pour cela que le temps imparti au créneau phiTR peut avoir une durée aussi faible que T0.

Il faut noter que l'on ne peut pas doubler l'ensemble des électrodes avec une couche d'aluminium parce que l'aluminium masque la lumière et doit donc être utilisé le moins possible dans la zone active de prise d'image du capteur ; mais il est acceptable de doubler la dernière électrode E4 et l'électrode de transfert.

Il peut être souhaitable de donner à la dernière électrode E4 de la dernière ligne une largeur supérieure à celle des autres électrodes E4 de la matrice pour faciliter le stockage des charges entièrement sous cette électrode à l'étape 4 avant ouverture de la barrière par phiTR.

L'invention est applicable également dans le cas où, pour accélérer la lecture au prix de la résolution d'image, on effectue un regroupement de pixels deux par deux en colonne (et éventuellement en ligne aussi). Dans ce cas, on effectue deux pas de transfert en colonne successifs avant d'ouvrir la porte de transfert vers le registre de lecture. Les charges de deux lignes successives s'accumulent sous la dernière électrode E4 de la dernière ligne, qui est plus large que les autres électrodes E4 de la matrice et qui est commandée par un signal qui passe au niveau haut seulement pendant la durée du créneau phi4 du deuxième pas de transfert mais pas lors du premier. L'électrode E4 de la dernière ligne n'est par conséquent pas commandée par le même signal de commutation que les autres électrodes E4 de la matrice. La porte de transfert est ouverte pendant un bref instant commençant avant la fin du deuxième créneau phi4 et se terminant après la fin de ce deuxième créneau. Là encore, on fait fonctionner le transfert horizontal pendant toute la durée de commutation des potentiels phi1 à phi4 des deux pas successifs, à l'exception du court intervalle de temps (pouvant descendre jusqu'à 2T0 voire même T0) pendant lequel la porte de transfert ouvre la barrière de potentiel qui sépare la matrice du registre de lecture. La même solution est adoptée pour un regroupement en colonne 4 lignes par 4 lignes ou 8 lignes par 8 lignes et le gain de temps est encore plus grand puisqu'il faut maintenant 16 ou 32 T0 pour le transfert en colonne et seulement 2T0 d'interruption du transfert horizontal.

Pour minimiser l'influence des commutations de signaux de commande phi1, phi2, phi3, phi4 pendant la lecture des charges transférées horizontalement par le registre de lecture vers le circuit de lecture, on prévoit des moyens de découplage équivalent à une sorte de blindage du circuit de lecture.

L'influence des commutations vient des très grosses lignes de nature capacitive que constituent les milliers d'électrodes E1 à E4 de la matrice. La commutation brusque du potentiel de ces lignes (toutes les lignes de même rang à la fois) induit par proximité une modification du potentiel du substrat sur lequel est intégrée la matrice. Certes le substrat est mis à la masse, en général par sa face arrière, mais le volume du substrat ne peut pas être complètement maintenu au potentiel de la masse, et la partie de substrat au voisinage de la surface avant (qui est la plus proche des électrodes) voit son potentiel varier capacitivement. Or le circuit de lecture est situé sur la face avant du substrat.

On estime donc qu'il est souhaitable de prévoir des moyens pour réduire cet effet de substrat, particulièrement néfaste avec le principe de l'invention puisque la lecture du registre horizontal a lieu pendant que se produisent des commutations sur ces grosses lignes capacitives.

De préférence, on entoure le circuit de lecture en sortie du registre par une électrode EL de face avant en contact ohmique direct avec le substrat sur lequel elle repose, cette électrode étant destinée à être reliée à une masse électrique à potentiel nul (même potentiel que la face arrière du substrat). Par exemple, l'électrode EL est reliée à un plot de contact PL de face avant, et ce plot de contact peut être relié à une broche extérieure de masse de la puce de circuit intégré. Sur la figure 2, on a représenté un fil de connexion extérieure FL, soudé sur ce plot et allant vers une broche de circuit reliée à une masse électrique à l'extérieur de la puce. Cette broche ou ce fil sont reliés, à l'extérieur de la puce, à la même masse que la face arrière de la puce.

La portion de substrat entourée par cette électrode de stabilisation de potentiel de substrat est ainsi moins soumise à l'effet de substrat que le reste du substrat. L'électrode entoure soit l'amplificateur AMP soit l'amplificateur et les circuits de remise à niveau de la diode de lecture. L'électrode est en contact avec le substrat soit ponctuellement de place en place soit sur toute sa longueur. Typiquement, si le substrat est un substrat de type P, dans lequel classiquement une couche superficielle de type N est prévue partout où des charges doivent être transportées, on prévoit que l'électrode est reliée en continu ou de point en point à une zone diffusée de type P⁺ rejoignant le substrat de type P.

Si l'amplificateur du circuit de lecture est à plusieurs étages, on entoure de préférence tous les étages.

Une autre manière d'isoler le circuit de lecture et le rendre indépendant des variations de potentiel de substrat dues aux commutations d'électrodes consiste à séparer physiquement la portion de substrat qui porte le circuit de lecture de la portion de substrat qui porte la matrice. Cette séparation peut se faire par des tranchées dans le cas de matrices formées dans du silicium mince reporté sur un substrat relativement isolant. Ces tranchées sont faites dans toute l'épaisseur du silicium pour constituer un îlot de substrat portant le circuit de lecture. La portion de substrat isolée par cette tranchée est reliée à un potentiel fixe de masse (par exemple par la face arrière de cette portion de substrat). Cet îlot, séparé du substrat principal portant les électrodes de la matrice et porté à un potentiel de masse indépendamment du reste du substrat, n'est pas influencé par les variations de potentiel du substrat principal lors des commutations de potentiel des électrodes de la matrice.

L'invention est applicable aux capteurs d'image dans lesquels il y a plusieurs registres de lecture (deux ou quatre) associés à différentes parties de la matrice, ou dans lesquelles le ou les registres ont plusieurs sorties, l'utilisation de plusieurs registres ou de registres à plusieurs sorties contribuant à une plus grande rapidité de fourniture de l'image totale.

## Revendications

1. Capteur d'image comprenant une matrice de prise de vue ayant N lignes et K colonnes de points d'image, un registre de lecture (RL) à l'extrémité libre des K colonnes, et des moyens pour transférer d'une ligne à l'autre, et de la dernière ligne au registre de lecture, des charges correspondant aux points d'image, avec une électrode de transfert (TR) entre la dernière ligne de la matrice et le registre de lecture, chaque ligne de points d'image comprenant plusieurs électrodes (E1, E2, E3, E4) de rang 1 à p, actionnées en synchronisme, de telle sorte que les électrodes de même rang j, avec j=1 à p, de toutes les lignes soient actionnées par un même signal de commande périodique (phi1, phi2, phi3, phi4), l'électrode de rang p étant, parmi les électrodes d'une même ligne, celle qui est la plus proche du registre de lecture, des moyens de commande du registre de lecture étant prévus pour effectuer un transfert de charges du registre vers un circuit de lecture (DL, AMP), interrompre ce transfert pendant qu'une barrière de potentiel sous l'électrode de transfert (TR) est abaissée, et reprendre ce transfert ensuite, ce capteur d'image étant **caractérisé en ce que** les moyens de commande sont agencés pour effectuer un transfert de charges d'une part pendant que les électrodes de ligne ne subissent aucune commutation de niveau de potentiel, et d'autre part pendant que les électrodes d'au moins un des rangs j = 1 à j = p subissent une commutation de niveau de potentiel lors d'une opération de transfert de charges en colonne, le transfert par le registre de lecture étant interrompu pendant que ladite barrière de potentiel sous l'électrode de transfert (TR) est abaissée.

2. Capteur d'image selon la revendication 1, **caractérisé en ce que** les moyens de commande du registre sont agencés pour poursuivre le transfert par le registre de lecture pendant toute la durée où les différentes électrodes de rang j = 1 à p subissent des commutations, sauf pendant le temps où la barrière de potentiel sous l'électrode de transfert est abaissée.

3. Capteur d'image selon la revendication 2, **caractérisé en ce que** les moyens de commande du registre sont agencés pour poursuivre le transfert par le registre de lecture pendant une partie du temps où les électrodes de rang 1 de la matrice sont à un niveau de potentiel haut.

4. Capteur d'image selon l'une des revendications 1 à 3, **caractérisé en ce que** l'électrode de transfert est commandée par un signal de commande (phiTR) qui n'est pas le même que celui qui commande les électrodes de rang 1.

5. Capteur d'image selon la revendication 4, **caractérisé en ce que** l'électrode de transfert a une résistivité notablement plus faible que la résistivité des électrodes de ligne de la matrice.

6. Capteur d'image selon l'une des revendications 1 à 5, **caractérisé en ce que** l'électrode de rang p de la dernière ligne de la matrice, celle qui est adjacente à l'électrode de transfert, a une surface plus grande que les autres électrodes de rang p de la matrice.

7. Capteur d'image selon l'une des revendications 1 à 6, **caractérisé en ce que** l'électrode de rang p de la dernière ligne de la matrice est commandée par un signal indépendant de celui des autres électrodes de même rang p.

8. Capteur d'image selon la revendication 7, **caractérisé en ce que** l'électrode de rang p de la dernière ligne de la matrice possède une résistivité plus faible que les autres électrodes de ligne de la matrice

9. Capteur d'image selon l'une des revendications 1 à 8, **caractérisé en ce que** la sortie du registre de lecture (RL) aboutit sur un circuit de lecture qui comprend un amplificateur réalisé sur une même puce de circuit intégré en silicium que la matrice, et des moyens pour neutraliser l'effet sur l'amplificateur des variations de potentiel du silicium lors des commutations de niveau de potentiel des électrodes de ligne de la matrice.

10. Capteur d'image selon la revendication 9, **caractérisé en ce que** les moyens pour neutraliser l'effet des variations de potentiel comprennent une électrode (EL) formée sur la même face de substrat que les électrodes de la matrice, cette électrode entourant l'amplificateur, et des moyens (PL, FL) pour relier cette électrode (EL) à un potentiel fixe de masse.

11. Capteur d'image selon la revendication 9, **caractérisé en ce que** les moyens pour neutraliser l'effet des variations de potentiel comprennent une tranchée dans le silicium autour de l'amplificateur et des moyens pour relier à un potentiel fixe de masse la portion de substrat entourée par cette tranchée.

12. Capteur selon l'une des revendication 1 à 11, **caractérisé en ce que** la matrice est une matrice de type MPP comportant quatre électrodes parallèles par ligne, actionnées selon une succession de dix phases pour le transfert d'un pas en colonne.

13. Capteur selon la revendication 12, **caractérisé en ce qu'**il comprend des moyens pour abaisser une barrière de potentiel sous l'électrode de transfert (TR) en même temps que ou après le passage à un niveau logique haut des électrodes de rang 2 et pendant que l'électrode de rang 4 est au niveau haut, et pour remonter cette barrière de potentiel avant ou en même temps qu'un passage de l'électrode de rang 3 à un niveau logique haut et alors que l'électrode de rang 4 est revenue au niveau bas.

14. Capteur selon l'une des revendications 1 à 13, **caractérisé en ce qu'**il comporte des moyens pour effectuer successivement deux transferts de charges d'une ligne à la suivante sans transfert , de charges de la dernière ligne vers le registre de lecture, et des moyens pour abaisser une barrière de potentiel sous l'électrode de transfert seulement à la fin du deuxième transfert de charges.

## Claims

1. Image sensor comprising a picture capture matrix having N rows and K columns of image dots, a read register (RL) at the free end of the K columns, and means for transferring, from one row to another and from the last row to the read register, charges corresponding to the image dots, with a transfer electrode (TR) between the last row of the matrix and the read register, each row of image dots comprising several electrodes (E1, E2, E3, E4) of rank 1 to p, activated synchronously, such that the electrodes of the same rank j, with j = 1 to p, of all the rows are activated by the same periodic control signal (phi1, phi2, phi3, phi4), the electrode of rank p being, among the electrodes of the same row, that which is the closest to the read register, means for controlling the read register being provided for carrying out a transfer of charge from the register towards a read circuit (DL, AMP), for interrupting this transfer while a potential barrier under the transfer electrode (TR) is lowered, and for subsequently restoring this transfer, this image sensor being **characterized in that** the control means are configured to perform a charge transfer, on the one hand, while the row electrodes are not undergoing any potential level switching, and on the other, while the electrodes of at least one of the ranks j = 1 to j = p undergo a potential level switching during a column charge transfer operation, the transfer by the read register being interrupted while said potential barrier under the transfer electrode (TR) is lowered.

2. Image sensor according to Claim 1, **characterized in that** the register control means are designed to continue the transfer by the read register during the whole time when the various electrodes of rank j = 1 to p undergo switching operations, except during the time when the potential barrier under the transfer electrode is lowered.

3. Image sensor according to Claim 2, **characterized in that** the register control means are configured to continue the transfer by the read register during part of the time when the electrodes of rank 1 of the matrix are at a high potential level.

4. Image sensor according to one of Claims 1 to 3, **characterized in that** the transfer electrode is controlled by a control signal (phiTR) that is not the same as that controlling the electrodes of rank 1.

5. Image sensor according to Claim 4, **characterized in that** the transfer electrode has a noticeably lower resistivity than the resistivity of the row electrodes of the matrix.

6. Image sensor according to one of Claims 1 to 5, **characterized in that** the electrode of rank p of the last row of the matrix, that which is adjacent to the transfer electrode, has a larger surface area than the other electrodes of rank p of the matrix.

7. Image sensor according to one of Claims 1 to 6, **characterized in that** the electrode of rank p of the last row of the matrix is controlled by a signal that is independent of that of the other electrodes of same rank p.

8. Image sensor according to Claim 7, **characterized in that** the electrode of rank p of the last row of the matrix has a lower resistivity than the other row electrodes of the matrix.

9. Image sensor according to one of Claims 1 to 6, **characterized in that** the output of the read register (RL) leads to a read circuit that comprises an amplifier fabricated on the same silicon integrated circuit chip as the matrix, and means for neutralizing the effect of the variations in potential of the silicon on the amplifier during the potential level switching of the row electrodes of the matrix.

10. Image sensor according to Claim 9, **characterized in that** the means for neutralizing the effect of the potential variations comprise an electrode (EL) formed on the same substrate face as the electrodes of the matrix, this electrode surrounding the amplifier, and means (PL, PF) for connecting this electrode (EL) to a fixed ground potential.

11. Image sensor according to Claim 9, **characterized in that** the means for neutralizing the effect of the potential variations comprise a trench in the silicon around the amplifier and means for connecting the portion of substrate surrounded by this trench to a fixed ground potential.

12. Sensor according to one of Claims 1 to 11, **characterized in that** the matrix is a matrix of the MPP type comprising four parallel electrodes per row activated according to a succession of ten phases for the transfer of one step down a column.

13. Sensor according to Claim 12, **characterized in that** it comprises means for lowering a potential barrier under the transfer electrode (TR) at the same time as, or following, the switching of the electrodes of rank 2 to a high logic level and while the electrode of rank 4 is at the high level, and for raising this potential barrier again before, or at the same time as, the electrode of rank 3 goes to a high logic level and when the electrode of rank 4 has returned to the low level.

14. Sensor according to one of Claims 1 to 13, **characterized in that** it comprises means for successively performing two charge transfers from one row to the next without charge transfer from the last row towards the read register, and means for lowering a potential barrier under the transfer electrode only at the end of the second transfer of charges.

## Patentansprüche

1. Bildsensor mit einer Bildaufnahmematrix mit N Zeilen und K Spalten von Bildpunkten, einem Leseregister (RL) am freien Ende der K Spalten, und Mitteln, um den Bildpunkten entsprechende Ladungen von einer Zeile zur anderen und von der letzten Zeile zum Leseregister zu übertragen, mit einer Transferelektrode (TR) zwischen der letzten Zeile der Matrix und dem Leseregister, wobei jede Zeile von Bildpunkten mehrere Elektroden (E1, E2, E3, E4) des Rangs 1 bis p aufweist, die synchron aktiviert werden, derart, dass die Elektroden gleichen Rangs, mit j=1 bis p, aller Zeilen vom gleichen periodischen Steuersignal (phi1, phi2, phi3, phi4) aktiviert werden, wobei die Elektrode des Rangs p unter den Elektroden der gleichen Zeile diejenige ist, die dem Leseregister am nächsten ist, wobei Mittel zur Steuerung des Leseregisters vorgesehen sind, um einen Ladungstransfer vom Register zu einer Leseschaltung (DL, AMP) durchzuführen, diesen Transfer zu unterbrechen, während eine Potentialschwelle unter der Transferelektrode (TR) abgesenkt wird, und diesen Transfer anschließend wieder aufzunehmen, wobei dieser Bildsensor **dadurch gekennzeichnet ist, dass** die Steuermittel ausgelegt sind, um einen Ladungstransfer einerseits, während die Zeilenelektroden keine Potentialpegelumschaltung erfahren, und andererseits, während die Elektroden mindestens eines der Ränge j=1 bis j=p eine Potentialpegelumschaltung bei einem Spalten-Ladungstransfervorgang erfahren, durchzuführen, wobei der Transfer durch das Leseregister unterbrochen ist, während die Potentialschwelle unter der Transferelektrode (TR) abgesenkt ist.

2. Bildsensor nach Anspruch 1, **dadurch gekennzeichnet, dass** die Steuermittel des Registers ausgelegt sind, um den Transfer durch das Leseregister während der ganzen Dauer fortzusetzen, während der die verschiedenen Elektroden des Rangs j=1 bis p Umschaltungen erfahren, außer während der Zeit, in der die Potentialschwelle unter der Transferelektrode abgesenkt ist.

3. Bildsensor nach Anspruch 2, **dadurch gekennzeichnet, dass** die Steuermittel des Registers ausgelegt sind, um den Transfer durch das Leseregister während eines Teils der Zeit fortzusetzen, während der die Elektroden des Rangs 1 der Matrix auf einem hohen Potentialpegel sind.

4. Bildsensor nach einem der Ansprüche 1 bis 3, **dadurch gekennzeichnet, dass** die Transferelektrode von einem Steuersignal (phiTR) gesteuert wird, das nicht das gleiche ist, das die Elektroden des Rangs 1 steuert.

5. Bildsensor nach Anspruch 4, **dadurch gekennzeichnet, dass** die Transferelektrode einen spezifischen Widerstand hat, der wesentlich schwächer ist als der spezifische Widerstand der Zeilenelektroden der Matrix.

6. Bildsensor nach einem der Ansprüche 1 bis 5, **dadurch gekennzeichnet, dass** die Elektrode des Rangs p der letzten Zeile der Matrix, diejenige, die der Transferelektrode benachbart ist, eine größere Fläche hat als die anderen Elektroden des Rangs p der Matrix.

7. Bildsensor nach einem der Ansprüche 1 bis 6, **dadurch gekennzeichnet, dass** die Elektrode des Rangs p der letzten Zeile der Matrix von einem Signal gesteuert wird, das unabhängig von demjenigen der anderen Elektroden des gleichen Rangs p ist.

8. Bildsensor nach Anspruch 7, **dadurch gekennzeichnet, dass** die Elektrode des Rangs p der letzten Zeile der Matrix einen schwächeren spezifischen Widerstand besitzt als die anderen Zeilenelektroden der Matrix.

9. Bildsensor nach einem der Ansprüche 1 bis 8, **dadurch gekennzeichnet, dass** der Ausgang des Leseregisters (RL) an einer Leseschaltung mündet, die einen Verstärker, der auf dem gleichen Siliciumchip einer integrierten Schaltung ausgebildet ist wie die Matrix, und Mittel aufweist, um die Wirkung der Potentialveränderungen des Siliciums bei Potentialpegelumschaltungen der Zeilenelektroden der Matrix auf den Verstärker zu neutralisieren.

10. Bildsensor nach Anspruch 9, **dadurch gekennzeichnet, dass** die Mittel zur Neutralisierung der Wirkung der Potentialveränderungen eine Elektrode (EL), die auf der gleichen Seite des Substrats ausgebildet ist wie die Elektroden der Matrix, wobei diese Elektrode den Verstärker umgibt, und Mittel (PL, FL) aufweisen, um diese Elektrode (EL) mit einem festen Massepotential zu verbinden.

11. Bildsensor nach Anspruch 9, **dadurch gekennzeichnet, dass** die Mittel zur Neutralisierung der Wirkung der Potentialveränderungen einen Graben im Silicium um den Verstärker herum und Mittel aufweisen, um den von diesem Graben umgebenen Substratabschnitt mit einem festen Massepotential zu verbinden.

12. Bildsensor nach einem der Ansprüche 1 bis 11, **dadurch gekennzeichnet, dass** die Matrix eine Matrix vom Typ MPP ist, die vier parallele Elektroden pro Zeile aufweist, die gemäß einer Folge von zehn Phasen für den Transfer eines Spaltenschritts aktiviert werden.

13. Bildsensor nach Anspruch 12, **dadurch gekennzeichnet, dass** er Mittel aufweist, um eine Potentialschwelle unter der Transferelektrode (TR) gleichzeitig mit oder nach dem Übergang der Elektroden des Rangs 2 auf einen hohen logischen Pegel, und während die Elektrode des Rangs 4 auf hohem Pegel ist, abzusenken, und um diese Potentialschwelle vor oder gleichzeitig mit einem Übergang der Elektrode des Rangs 3 auf einen hohen logischen Pegel, und während die Elektrode des Rangs 4 auf den niederen Pegel zurückgekommen ist, wieder anzuheben.

14. Bildsensor nach einem der Ansprüche 1 bis 13, **dadurch gekennzeichnet, dass** er Mittel, um nacheinander zwei Ladungstransfers von einer Zeile zur anderen ohne Ladungstransfer von der letzten Zeile zum Leseregister durchzuführen, und Mittel aufweist, um eine Potentialschwelle unter der Transferelektrode nur am Ende des zweiten Ladungstransfers abzusenken.
